# EUROPÄISCHE PATENTANMELDUNG

(11) **EP 0 724 980 A1**
(43) Veröffentlichungstag der Anmeldung: **07.08.1996**
(21) Anmeldenummer: 95119766.4
(22) Anmeldetag: 14.12.1995
(51) Int. Cl.: B60L 3/04, H02H 3/20

(54) **Fahrzeug mit einem brennstoffzellen- oder batteriegespeisten Energieversorgungsnetz**

(30) Priorität: 04.02.1995 DE 19503749
(71) Anmelder: DAIMLER-BENZ AKTIENGESELLSCHAFT, D-70567 Stuttgart (DE)
(72) Erfinder: Sonntag, Josef, Dipl.-Ing., D-89257 Illertissen (DE)

(57) **Zusammenfassung**

2.1. Es ist bekannt, eine Leitung des Laststromkreises eines Elektrofahrzeuges auf Fahrzeugkarosseriepotential zu legen. Dies kann zu Berührspannungsgefahren und Korrosionsproblemen aufgrund von Brennstoffzellen- oder Batterieleckströmen führen. Stationäre Energieversorgungsnetze können als IT-Netz realisiert sein, bei dem die elektrischen Verbraucher untereinander zum Schutz vor hohen Berührungsspannungen mit einem gemeinsamen Schutzleiter verbunden sind. Die Isolation der Laststromleitungen kann beispielsweise mittels einer Brückenschaltung überwacht werden, welche bei einer Unsymmetrie der Isolationswiderstände anspricht.

2.2. Es wird vorgeschlagen, das brennstoffzellen- oder batteriegespeiste Energieversorgungsnetz eines Fahrzeuges als IT-Netz auszuführen, bei dem die mit dem Laststromkreis verknüpften Verbraucher niederohmig mit der Fahrzeugkarosserie elektrisch verbunden sind. Bevorzugt ist zusätzlich eine aus einer Meßbrückenabgleichstufe und einer meßsignalaufbereitenden Trennverstärkerstufe bestehende Isolationsüberwachungseinrichtung zwischen den Laststromkreis und die Fahrzeugkarosserie eingeschleift.

2.3. Verwendung z.B. für Elektrofahrzeuge.

## Beschreibung

Die Erfindung bezieht sich auf ein Fahrzeug mit einem brennstoffzellen-oder batteriegespeisten Energieversorgungsnetz, wie z.B. ein Elektrofahrzeug mit brennstoffzellengespeistem bzw. batteriegespeistem Elektroantrieb. Ein derartiges Fahrzeug ist beispielsweise in der Patentschrift DE 33 39 890 C2 offenbart. Bei dem daraus bekannten Energieversorgungsnetz ist ein Anschluß der Batterie ebenso wie jeweils ein Anschluß der von der Batterie gespeisten stromverbrauchenden Anlagenteile und folglich eine der beiden Laststromkreisleitungen auf das Potential der Fahrzeugkarosserie gelegt.

Beim Auftreten von Gleichspannungen, die eine maximale Berührungsspannung von 120V überschreiten, muß in solchen Netzen gemäß einer VDE-Vorschrift ein Schutz gegen indirektes Berühren bereitgestellt werden. Bei brennstoffzellen- oder batteriegetriebenen Kraftfahrzeugen besteht außerdem eine erhöhte Gefahr von Isolationsfehlern durch die mechanische Belastung in Form von Vibrationen. In Batterie- oder Brennstoffzellensystemen, z.B. aus PEM-Brennstoffzellen, können aufgrund der Gas- und Fluidkreisläufe elektrische Leckströme auftreten, die gefährliche Berührungsspannungen zwischen verschiedenen Betriebsmitteln hervorrufen und zudem zu Korrosionserscheinungen führen können. Zudem besteht die Gefahr, daß auftretende Lichtbögen als Zündquelle dienen. Wegen den anlagenbedingten Leckströmen können Fehlerstrom(FI)- oder Fehlerspannungs(FU)-Schutzschalter als Berührungsspannungsschutz nicht eingesetzt werden. Bei Brennstoffzellensystemen, die in stationären Anlagen im Einsatz sind, können die entsprechenden Anlagenteile direkt mit Erde elektrisch verbunden werden. Dies ist für nichtstationäre, mobile Systeme, wie Fahrzeuge, nicht in dieser Weise möglich, so daß hier der Bedarf nach einer anderen Schutzmaßnahme besteht.

Als eine Möglichkeit der Auslegung eines begrenzten Energieversorgungsnetzes mit eigenem Transformator oder Generator ist das sogenannte IT-Netz bekannt, siehe Norm-Entwurf zu DIN VDE 0100, Teil 410 A3, Abschnitt 413, Juni 1989. Beim IT-Netz wird eine zu hohe Berührungsspannung dadurch verhindert, daß alle zu schützenden Verbraucher untereinander mit einem Erdungsschutzleiter verbunden werden, gegenüber dem der Laststromkreis isoliert ist. Der Isolationswiderstand des Laststromkreises wird herkömmlicherweise durch ein Isolationsüberwachungsgerät laufend kontrolliert.

Aus der Patentschrift DD 121 858 ist beispielsweise eine Erdschlußüberwachung für isoliert betriebene Gleichstromnetze bekannt, bei der über einen Spannungsteiler ein Netzpunkt mit Erdpotential geschaffen und dieser über einen Widerstand mit Erdpotential verbunden wird. Bei einer Anordnung, wie sie in der Patentschrift DE 688 497 beschrieben ist, wird zur Überwachung des Isolationswiderstandes an einem Gleichspannungsnetz für Oberleitungsomnibusse ein Relais verwendet, von dem je eine von zwei gegeneinander geschalteten Erregerspulen zwischen einen der beiden Stromabnehmer und die Fahrzeugmasse eingeschleift ist. Aus der Patentschrift CH 613 313 A5 ist eine Einrichtung zur Isolationsüberwachung eines nicht geerdeten Gleichstromnetzes mit einer zwischen den Netzleitern liegenden Brückenschaltung bekannt, bei welcher der eine Brückenzweig aus Hilfswiderständen und der andere Brückenzweig aus den Isolationswiderständen der Netzleiter gegen Erde gebildet ist. Eine die Unsymmetrie der Isolationswiderstände erfassende Überwachungsschaltung beinhaltet ein Koppelglied zur nichtgalvanischen Signalübertragung, dessen Eingangselement ein von der genannten elektrischen Unsymmetrie abhängiges Signal abgibt, das von einem Ausgangselement erfaßt und in ein elektrisches Erkennungssignal umgesetzt wird.

Der Erfindung liegt als technisches Problem die Bereitstellung eines Fahrzeugs mit einem brennstoffzellen- oder batteriegespeisten Energieversorgungsnetz zugrunde, das gegen hohe Berührungsspannungen und die Brandsicherheit gefährdende Zündquellen Betriebssicherheit gewährleistet und gegen übermäßige Korrosion geschützt ist.

Dieses Problem wird durch ein Fahrzeug mit den Merkmalen des Anspruchs 1 gelöst. Hierzu ist der Laststromkreis des brennstoffzellen- oder batteriegespeisten Energieversorungsnetzes nach Art eines IT-Netzes ausgeführt, bei dem die eine Laststromkreisleitung über und die andere unter dem Potential der Fahrzeugkarosserie liegt und bei dem die mit dem Laststromkreis verknüpften Fahrzeugkomponenten niederohmig, z.B. mit einem Widerstandswert von kleiner als 1Ω, mit der Fahrzeugkarosserie elektrisch verbunden sind.

Eine Weiterbildung der Erfindung nach Anspruch 2 bietet in einer vorteilhaften Weise die Möglichkeit zur Überwachung des Isolationswiderstandes zwischen den Laststromkreisleitungen und der Fahrzeugkarosserie mittels einer Meßbrückenabgleichstufe und einer deren Meßsignal aufbereitenden Trennverstärkerstufe. Diese Anordnung kommt folglich mit einer einzigen Meßbrückenabgleichstufe und einem einzigen Trennverstärker zur Isolationsüberwa chung beider Laststromkreisleitungen aus. In Ausgestaltung der Erfindung nach Anspruch 3 ist vorgesehen, den Laststromkreis so ausreichend hochohmig mit der Fahrzeugkarosserie zu verbinden, daß einerseits das Auftreten zu hoher Ableitströme und andererseits ein ungewolltes Ansprechen der Isolationsüberwachung bei unterhalb eines vorgegebenen Schwellenwertes liegenden Brennstoffzellen-oder Batterieleckströmen verhindert wird.

In einer Weiterbildung der Erfindung nach Anspruch 4 besitzt die Isolationsüberwachungseinrichtung einen oder mehrere Trimmpotentiometer, um die der Meßbrückenabgleichstufe zugeführten Laststromkreisspannungen bezüglich des Fahrzeugkarosseriepotentials symmetrieren und/oder den Meßbereich der Meßbrückenabgleichstufe an vorgebbare Alarmgrenzen bzw. den Trennverstärkermeßbereich anpassen zu können.

Eine bevorzugte Ausführungsform der Erfindung ist in den Zeichnungen dargestellt und wird nachfolgend beschrieben. Hierbei zeigen:
- Fig 1: einen Schaltplan eines brennstoffzellengespeisten Energieversorgungsnetzes eines Elektrofahrzeuges und
- Fig. 2: ein detailliertes Schaltbild einer in dem brennstoffzellengespeisten Energieversorgungsnetz von Fig. 1 vorgesehenen Isolationsüberwachungseinrichtung.

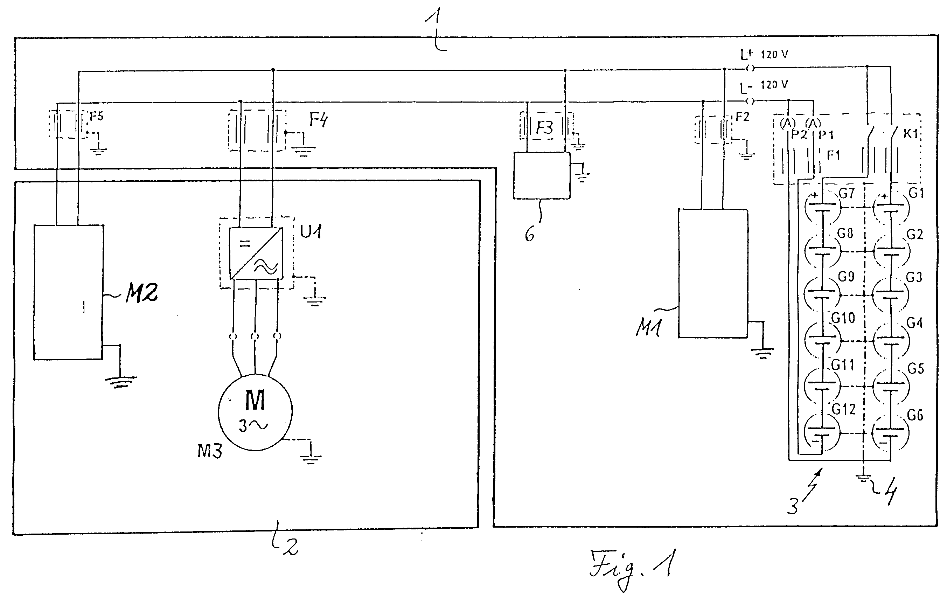

Das in Fig. 1 schaltplanmäßig dargestellte, brennstoffzellengespeiste Energieversorgungsnetz eines Elektrofahrzeuges gliedert sich in einen Stromerzeugungssystemteil (1) und einen Fahrzeugverbraucherteil (2). Als elektrische Energiequelle enthält das Stromerzeugungssystem (1) einen Brennstoffzellenstapel (3) aus zwei parallelen Reihen von je sechs PEM-Brennstoffzellen (G1 bis G12). Die positiven Ausgänge der beiden Brennstoffzellenreihen sind über Sicherungen und ein Schaltelement (K1) zu einem positiven Versorgungsspannungsanschluß geführt, von dem die positive Leitung (L⁺) des Laststromkreises für das Elektrofahrzeug abgeht. Analog sind die negativen Ausgänge der beiden Brennstoffzellenreihen über Sicherungen (F1) und Strommeßeinrichtungen (P1, P2) gemeinsam zu einem negativen Spannungsversorgungsanschluß geführt, von dem die negative Leitung (L⁻) des Laststromkreises abgeht. Bevorzugt wird eine zweipolige Trennung durch das Schaltelement (K1).

Der Laststromkreis ist hierbei als IT-Netz verschaltet, d.h. alle stromverbrauchenden Anlagenteile werden über die beiden Laststromkreisleitungen (L⁺, L⁻) gespeist, die mit der Fahrzeugkarosserie hochohmig durch eine Isolationsüberwachung (6) verbunden sind, während als Schutzmaßnahme vor zu hoher Berührungsspannung alle zu schützenden Anlagenteile untereinander niederohmig mit einem Restwiderstand kleiner als 1Ω mit der Fahrzeugkarosserie verbunden sind. Die Karosserie ist in Fig. 1 deshalb durch das Erdungszeichen (4) symbolisiert. Das IT-Netz ist potentialmäßig symmetrisch zum Karosseriepotential ausgelegt, d.h. die Spannung (-120V) auf der negativen Laststromkreisleitung (L⁻) entspricht dem negativen Wert der Spannung (+120V) auf der positiven Laststromkreisleitung (L⁺), wobei ohne Beschränkung der Allgemeinheit das Karosseriepotential mit 0V angenommen wird. Diese Laststromkreissymmetrierung hat den Vorteil, daß bei einem Schadensfall, z.B. im Brennstoffzellenstapel (3), der einen Leckstromfluß zwischen einer Laststromkreisleitung (L⁺ oder L⁻) zur Karosserie (4) und zurück über den hochohmigen Widerstand der Isolationsüberwachung (6) verursacht, dieser Leckstrom bei einer Spannungsdifferenz von 240V und einem Isolationswiderstand deutlich über 10kΩ sehr gering ist. Würde hingegen eine Laststromkreisleitung auf Karosseriepotential gelegt, so könnte im Schadensfall von der anderen Laststromkreisleitung zur Karosserie ein Kurzschlußstrom entsprechend einer Spannungsdifferenz von 240V und einen Widerstand nahe 0Ω entstehen. Da Leckströme häufig Korrosionen verursachen, lassen sich letztere durch die bevorzugt gewählte Laststromkreissymmetrierung kleiner halten als im unsymmetrischen Fall, und zwar durch die halbierte Spannungsdifferenz von 120V statt 240V bei einseitiger Erdung und die hochohmige Isolationsüberwachung zwischen Laststromkreis (L⁺, L⁻) und Chassis, was bei einseitiger Erdung nicht möglich ist.

Vom Laststromkreis (L⁺, L⁻) werden noch innerhalb des Stromerzeugungssystems Hilfsantriebe (M1) unter Zwischenschaltung jeweiliger Sicherungen (F2) und DC/AC-Wandler mit Dreiphasenwechselstrom elektrisch versorgt. Diese Hilfsantriebe (M1) werden für den Brennstoffzellenfluidkreislauf benötigt. In gleicher Weise speist der Gleichstrom-Laststromkreis mit den Brennstoffzellen (G1 bis G12) als elektrische Energiequellen über Vorsicherungen (F4, F5) im Fahrzeugverbraucherteil (2) angeordnete Hilfsantriebe (M2) und den Fahrmotor (M3) des Elektrofahrzeuges mit vorgeschaltetem DC/AC-Wandler (U1) mit Dreiphasenwechselstrom. Das als IT-Netz ausgelegte, brennstoffzellengespeiste Energieversorgungsnetz ist des weiteren mit einer Isolationsüberwachungseinrichtung (6) im Stromerzeugungssystemteil (1) ausgestattet. Diese Einrichtung (6) bildet eine ausreichend hochohmige Verbindung der beiden Laststromkreisleitungen (L⁺, L⁺) gegen das Fahrzeugkarosseriepotential (4), vorzugsweise mit einem Widerstandswert größer als 10kΩ, wobei die Überwachungseinrichtung (6) über Vorsicherungen (F3) an die Laststromkreisleitungen (L⁺, L⁻) angeschlossen ist. Der von der Isolationsüberwachungseinrichtung (6) bereitgestellte und überwachte Isolationswiderstand der Laststromkreisleitungen (L⁺, L⁻) gegenüber dem Fahrzeugchassis (4) ist ausreichend hochohmig ausgeführt, um einerseits ein Ansprechen der Isolationsüberwachung bei kleinen Brennstoffzellenleckströmen unterhalb eines vorgebbaren Schwellenwertes von ca. 1mA bis 5mA zu vermeiden und andererseits sicherzustellen, daß der im Fehlerfall eventuell auftretende Ableitstrom multipliziert mit dem Erdungswiderstand aller mit dem Chassis verbundenen Anlagenteile kleiner ist als die maximal zulässige Berührungsspannung von 120V. Bevorzugt wird ein maximaler Ableitstrom unter 100mA.

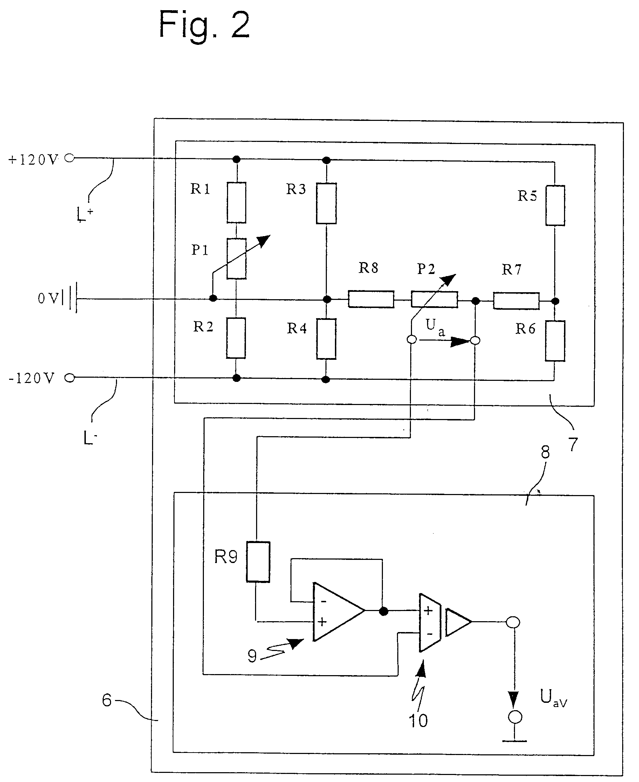

In Fig. 2 ist der genaue Aufbau der Einrichtung (6) zur Isolationswiderstandsüberwachung schaltungstechnisch im Detail dargestellt. Sie besteht aus einer Meßbrückenabgleichstufe (7) und einer nachgeschalteten, meßsignalaufbereitenden Trennverstärkerstufe (8). Der Meßbrückenabgleichstufe (7) sind die beiden Laststromkreisleitungen (L⁺, L⁻), die im Normalfall auf +120V beziehungsweise -120V liegen, sowie das 0V-Karosseriepotential eingangsseitig zugeführt. Zwischen den Laststromkreispotentialen liegen eingangsseitig ein erster Spannungsteiler mit zwei gleich großen Widerständen (R3, R4) von z.B. je 10kΩ sowie ein zweiter, aus zwei gleich großen und gegenüber denjenigen des ersten Spannungsteilers höherohmigen Widerständen (R1, R2) sowie einem dazwischenliegenden Trimmpotentiometer (P1) bestehender Spannungsteiler. Der Angriff des Trimmpotentiometers (P1) ist ebenso wie der Mittelpunkt des ersten Spannungsteilers an das Karosseriepotential angeschlossen. Durch das Trimmpotentiometer (P1) läßt sich aufgrund dieser Verschaltung die Symmetrierung der Systemspannung exakt aufrecht erhalten bzw. wiederherstellen. Zwischen den Mittelpunkt eines dritten, zu den ersten beiden parallel zwischen den Laststromkreispotentialen (+120V, -120V) liegenden Spannungsteilers mit z.B. denjenigen (R1, R2) des zweiten Spannungsteilers entsprechenden Widerständen (R5, R6) und den Mittelpunkt des ersten Spannungsteilers ist eine Meßbrücke in Form einer Serienschaltung aus einem ersten, niederohmigeren Widerstand (R8), z.B. 4,7kΩ, einem zweiten Trimmpotentiometer (P2) und einem höherohmigeren Widerstand (R7), z.B. 33kΩ, eingeschleift.

Zwischen dem Mittelabgriff des zweiten Trimmpotentiometers (P2) und dem zum höherohmigeren Widerstand (R7) gelegenen Potentiometeranschluß wird die Ausgangsspannung (Uₐ) der Meßbrückenabgleichstufe (7) abgegriffen, welche Abweichungen von der Spannungssymmetrierung und damit mögliche Isolationswiderstandsveränderungen anzeigt. Diese Ausgangsspannung (Uₐ) wird der Trennverstärkerstufe (8) zugeführt, wobei ein Anschluß direkt auf den invertierenden Eingang eines Trennverstärkers (10) gegeben wird, während der andere Eingangszweig über einen Widerstand (R9) an den nichtinvertierenden Eingang eines durch Rückkopplung seines Ausgangssignals an den invertierenden Eingang als Impedanzwandler geschalteten Operationsverstärkers (9) geführt ist. Der Impedanzwandlerausgang ist zum nichtinvertierenden Trennverstärkereingang geführt. Am Ausgang des Trennverstärkers (10) steht dann das der Isolationswiderstandsüberwachung dienende Ausgangsspannungssignal (Uₐᵥ) an. Der Impedanzwandler-Operationsverstärker (9) stellt einen hochohmigen Eingang für den Trennverstärker (10) bereit und verhindert dadurch eine zu starke Belastung der Meßbrücke (R8, P2, R7). Über eine entsprechende Einstellung des zweiten Trimmpotentiometers (P2) läßt sich die dort abfallende Spannung (Uₐ) jeweils so einstellen, daß sie durch die Trennverstärkerstufe (8) auf den Ausgangssignalbereich des Trennverstärkers (10), der z.B. durch den Bereich zwischen 0V und 10V gebildet ist, abgebildet wird.

Solange kein Schadensfall vorliegt, fällt über der Meßbrücke (R8, P2, R7) ersichtlich keine Spannung ab, da beide Eingangsknoten auf 0V liegen. Sobald ein Schadensfall eintritt, der die beiden Laststromkreisspannungen gegenüber dem Nullpotential unsymmetrisch macht, fällt an der Meßbrücke (R8, P2, R7) eine Spannung ungleich null ab, so daß der Schadensfall detektierbar ist. Tritt beispielsweise ein Kurzschluß zwischen der positiven Laststromkreisleitung (L⁺) und Masse auf, so fällt über der Meßbrücke (R8, P2, R7) dieselbe Spannung von 120V ab wie über dem Widerstand (R5), während über dem Widerstand (R3) keine Spannung abfällt. Über das Meßbrückenpotentiometer (P2) und die Trennverstärkerstufe (8) wird die geänderte Meßbrückenspannung in eine entsprechend geänderte, detektierbare Ausgangssignalspannung der Trennverstärkerstufe (8) umgewandelt. Funktionell analoge Verhältnisse ergeben sich für die anderen, in Betracht kommenden Schadensfälle.

Erkennbar benötigt die Einrichtung (6) zur Überwachung des Isolationswiderstandes, die nach dem Prinzip einer abgeglichenen Meßbrücke funktioniert, nur eine einzige meßsignalaufbereitende Trennverstärkerstufe (8) für beide Laststromkreisleitungen (L⁺, L⁻). In nicht näher gezeigter Weise können in einem Kraftfahrzeug-Steuergerät durch Vorgabe entsprechender Spannungsschwellenwerte eine oder mehrere Alarmstufen eingestellt werden. Beispielsweise kann bei einer ersten, niedrigeren Abweichung die Auslösung eines Voralarms durch ein optisches und/oder akustisches Warnsignal und bei Auftreten einer größeren Abweichung dann die Auslösung eines Hauptalarms erfolgen, bei dem eine Systemabschaltung stattfindet.

Das beschriebene Energieversorgungsnetz bietet folglich durch Realisierung als IT-Netz mit Isolationsüberwachung einen zuverlässigen Schutz vor zu hohen Berührungsspannungen und Berührungsströmen und wirkt somit dem Auftreten übermäßiger Korrosion durch Brennstoffzellenleckströme entgegen. Weitere Vorteile sind die Brandsicherheit und die Betriebssicherheit. Es versteht sich, daß ein erfindungsgemäßes Energieversorgungsnetz in analoger Weise auch für andere Fahrzeugtypen als Elektrofahrzeuge verwendbar ist, bei denen die Speisung eines solchen Netzes durch Brennstoffzellen bzw. durch andere Batterietypen vorgesehen ist.

## Patentansprüche

1. Fahrzeug mit einem brennstoffzellen- oder batteriegespeisten Energieversorgungsnetz,
**dadurch gekennzeichnet, daß**
- der Laststromkreis nach Art eines IT-Netzes ausgelegt ist, wobei die eine (L⁺) der beiden, die angeschlossenen stromverbrauchenden Anlageteile speisenden Laststromkreisleitungen (L⁺, L⁻) auf ein Potential oberhalb und die andere (L⁻) auf ein Potential unterhalb des Potentials der Fahrzeugkarosserie (4) gelegt ist und wobei die Laststromkreisleitungen (L⁺, L⁻) mit der Fahrzeugkarosserie (4) hochohmig verbunden sind, und daß
- die an den Laststromkreis angeschlossenen, stromverbrauchenden Anlagenteile niederohmig mit der Fahrzeugkarosserie (4) elektrisch verbunden sind.

2. Fahrzeug nach Anspruch 1, weiter
**gekennzeichnet durch**
eine Einrichtung (6) zur Überwachung des Isolationswiderstandes zwischen dem Laststromkreis (L⁺, L⁻) und der Fahrzeugkarosserie (4), wobei die Einrichtung eine Meßbrückenabgleichstufe (7) und eine meßsignalaufbereitende Trennverstärkerstufe (8) beinhaltet.

3. Fahrzeug nach Anspruch 2, weiter
**dadurch gekennzeichnet, daß**
der Laststromkreis (L⁺, L⁻) dergestalt hochohmig mit der Fahrzeugkarosserie (4) elektrisch verbunden ist, daß einerseits keine Ableitströme größer als 100mA entstehen und andererseits die Einrichtung (6) zur Überwachung des Isolationswiderstandes bei Brennstoffzellen- oder Batterieleckströmen unterhalb eines zwischen 1mA und 5mA liegenden Schwellenwertes noch nicht anspricht.

4. Fahrzeug nach Anspruch 2 oder 3, weiter
**dadurch gekennzeichnet, daß**
die Meßbrückenabgleichstufe (7) einen oder mehrere Trimmpotentiometer (P1, P2) zur Symmetrierung der zugeführten Spannungen der Laststromkreisleitungen (L⁺, L⁻) bezüglich des Fahrzeugkarosseriepotentials (4) und/oder zur Ausgangssignalanpassung an den Meßbereich der Trennverstärkerstufe (8) mit vorgebbaren Alarmgrenzen aufweist.
